# EUROPEAN PATENT SPECIFICATION

(11) **EP 1 696 006 B1**
(45) Date of publication and mention of the grant of the patent: **17.06.2009**
(21) Application number: 05101515.4
(22) Date of filing: 28.02.2005
(51) Int. Cl.: C09D 11/00, H05K 3/12

(54) **metal ink and substrate for a display and method for manufacturing the same**
Metallische Tinte und Substrat für eine Anzeige und deren Fertigungsmethode
Encre métallique et substrate d'affichage et procédé de fabrication correspondant

(43) Date of publication of application: 30.08.2006
(73) Proprietor: Samsung SDI Germany GmbH, 12459 Berlin (DE); Samsung SDI Co., Ltd., Suwon-si Gyeonggi-do (KR)
(72) Inventor: Klyszcz, Andreas Dr., 14050, Berlin (DE); Schaedig, Marcus, 15711, Königs Wusterhausen (DE); Humbs, Werner Dr., 12555, Berlin (DE)
(74) Representative: Hengelhaupt, Jürgen

(56) References cited:
- EP-A- 1 323 793
- EP-A- 1 349 135
- WO-A-20/04069941
- US-A- 4 415 624
- US-A- 4 518 833
- US-A- 4 670 351
- US-A- 4 722 853
- US-A- 5 514 451
- US-A1- 2003 213 614
- US-A1- 2004 142 165
- US-B1- 6 641 860
- PATENT ABSTRACTS OF JAPAN vol. 009, no. 021 (C-263), 29 January 1985 (1985-01-29) & JP 59 170167 A (DAITOU KASEI KOGYO KK; others: 02), 26 September 1984 (1984-09-26)
- PATENT ABSTRACTS OF JAPAN vol. 018, no. 377 (C-1225), 15 July 1994 (1994-07-15) & JP 06 100818 A (SHIN ETSU CHEM CO LTD), 12 April 1994 (1994-04-12)
- PATENT ABSTRACTS OF JAPAN vol. 2000, no. 16, 8 May 2001 (2001-05-08) & JP 2001 014943 A (HARIMA CHEM INC), 19 January 2001 (2001-01-19)

## Description

### FIELD OF THE INVENTION

This invention relates to a metal ink for ink jet printing of conductive lines and a method for manufacturing the same and a substrate for a display having a plurality of ink jet printed conductive lines and a method for manufacturing the same. More specifically, this invention relates to a metal ink and a substrate for a PDP having a plurality of ink jet printed conductive lines for address and bus electrodes.

### BACKGROUND OF THE INVENTION

Ink jet printed bus and address electrodes in PDPs are printed using nano-particle ink. Silver nano-particle ink is composed of individually dispersed metal nanoparticles, surfactants and organic particles (EP1349135A1, US20040043691A1, ULVAC).

US2004/0038616A1 (Fujitsu) describes a method of manufacturing a substrate for a flat panel display, the method comprising: forming a plurality of grooves in the bottom of a float glass substrate by a subtractive process to form barrier ribs comprising protrusions remaining between the respective grooves, and then forming electrodes on the bottoms of the grooves by an ink-jet process or a dispensing process. An alternative process to form narrow metal lines on glass or ITO surfaces using the nano-particle ink is to treat the substrate moderately and to have a contact angle of 60° for the nano-particle ink (US20030083203A, Seiko Epson; M. Furusawa et al, SID 02 Digest, 753 - 755). In conventional surface treatment methods, like fluorination with CF₄, C₂F₆, C₃F₈ or fluoroalkyl-functionalized silanes contact angles of 20° to 60° can be achieved, but the drawback is a loss in adhesion for the printed and cured metal lines.

US 6,387,519 B1 describes multi-component composite coatings of highly scratch resistant color-plus-clearcoatings capable of retaining scratch resistance after weathering.

US 6,118,426 describes a process for creating an electronically addressable display which includes multiple printing operations, similar to a multi-color process in conventional screen printing. In some of the process steps, electrically non-active inks are printed onto areas of the receiving substrate, and in other steps, electrically active inks are printed onto different areas of the substrate.

US 2003/168639 describes a metallic nano particle cluster ink and a method for forming a conductive metal pattern using the cluster ink. The metallic nano particle cluster ink comprises colloidal metallic nano particles and a bifunctional compound. The conductive metal pattern is formed by forming a metallic nano particle pattern on a substrate using a mold made from PDMS (poly(dimethylsiloxane)-polymer) as a stamp, and heat-treating the substrate. Micrometer-sized conductive metal patterns can be easily formed on various substrates in a simple and inexpensive manner without the use of costly systems, thereby being very useful in various industrial fields.

EP 1383597 describes a metal nano particle colloid solution, metal-polymer nanocomposites, and methods for preparing the same. The metal nano particle colloid solution and the metal-polymer nanocomposites can be prepared with a variety of polymeric stabilizers and have uniform particle diameter and shape. The metal nano particle colloid solution and the metal-polymer nanocomposites have wide applications, for example, as an antibacterial agent, a sterilizer, a conductive adhesive, conductive ink or an electromagnetic wave shield for an image display.

JP 2004/207659 describes a water-shedding printing part formed by printing a water-shedding ink in a non-circuit pattern region in the surface of a substrate. A water-system colloidal solution, wherein conductive nano metallic powder of an average grain diameter of 0.1 to 50 nm is dispersed, is applied to the surface of the substrate, and the colloidal solution is attached to only the non-printing part of the substrate which becomes a circuit pattern region. Then, the substrate is heated, the conductive nano metallic powder is fused mutually by evaporating liquid alone in the colloidal solution, and a conductive metallic layer consisting of nano metallic powder is formed in the non-printing part. A circuit is manufactured in this way.

All the above-cited techniques do not comprise sufficient abrasion resistance, adhesion and flexibility of ink printed on a substrate.

### OBJECTS OF THE INVENTION

Therefore one object of the invention is to improve the adhesion of ink jet printed conductive lines, for example ink jet printed address and bus electrodes on a ground substrate. Another object of the invention is to improve the abrasion resistance and the flexibility of ink jet printed conductive lines in order to increase the life time of said ground substrates and to allow flexible ground substrates.

### SUMMARY OF THE INVENTION

In one aspect of the invention a metal ink for ink jet printing of conductive lines is proposed which results in an improvement of abrasion resistance and of flexibility of ink jet printed conductive lines. Therefore a metal ink according to the invention comprises dispersed metal nano powder and a solvent wherein the metal ink comprises anti abrasive promoting nano particles and/or flexible promoting polymers. Preferably dispersed metal nano powder comprises silver, gold, platinum, palladium nickel and/or copper.

The anti abrasive promoting nano particles result in an improvement of abrasion resistance whereby the flexible promoting polymers result in an improvement of the flexibility of the (metal) ink jet printed conductive lines. In a preferred embodiment of the invention the anti abrasive promoting nano particles are colloidal and/or fumed silica nano particles and/or sol-gel nano particles and/or carbon nano particles and the flexible promoting polymers are silicone polymers and/or functionalised silicone polymers.

Preferably the silicone polymer comprises at least one polysiloxane of the formula (I):

R¹ *ₙ*R² *ₘ*SiO(₄-*ₙ*-*ₘ*)_{/2} (I)

wherein each R¹, which may be identical or different, represents H, OH, a monovalent hydrocarbon group or a monovalent siloxane group; each R² which may be identical or different, represents a group comprising at least one reactive functional group, wherein m and n fulfil the requirements of 0<n<4, 0<m<4 and 2≤(m+n)<4.

Preferably each of R², which may be identical or different, represents a group comprising at least one reactive functional group selected from a hydroxyl group, a carboxyl group, an isocyanate group, a blocked polyisocyanate group, a primary amine group, a secondary amine group, an amide group, a carbamate group, a urea group, a urethane group, a vinyl group, an unsaturated ester group, a maleimide group, a fumarate group, an anhydride group, a hydroxy alkylamide group, and an epoxy group.

In a preferred embodiment of the invention the silicone polymer comprises at least one polysiloxane of the formula (II) or (III)

R₃Si-O-(SiR₂O-)*ₙ*-(SiRR^{a}O)*ₘ*-SiR₃ (II)

R^{a}R₂Si-O-(SiR₂O-)*ₙ*-(SiRR^{a}O)*ₘ*-SiR₂R^{a} (III)

wherein
m has a value of at least 1;
m' ranges from 0 to 75;
n ranges from 0 to 75;
n' ranges from 0 to 75;
each R, which may be identical or different, is selected from H, OH, monovalent hydrocabon groups, monovalent siloxane groups, and mixtures of any of the foregoing; and
R^{a} comprises the following formula (IV):

-R³-X (IV)

wherein
-R³ is selected from an alkylene group, an oxyalkylene group, an alkylene aryl group, an alkenylene group, an oxyalkenylene group, and an alkenylene aryl group; and
X represents a group which comprises at least one reactive functional group selected from a hydroxyl group, a carboxyl group, an isocyanate group, a blocked polyisocyanate group, a primary amine group, a secondary amine group, an amide group, a carbamate group, a urea group, a urethane group, a vinyl group, an unsaturated ester group, a maleimide group, a fumarate group, an anhydride group, a hydroxy alkylamide group, and an epoxy group.

In a preferred embodiment of the invention the silicone polymer comprises at least one polysiloxane which is the reaction product of at least one the following reactants:
(i) at least one polysiloxane of the formula (V):

   R₃Si-O-(SiR₂O-)*ₙ*-SiR₃ (V)

   wherein each substituent group R, which may be identical or different, represents a group selected from H, OH, a monovalent hydrocarbongroup, a siloxane group, and mixtures of any of the foregoing; at least one of the groups represented by R is H, and n' ranges from 0 to 100, so that the percent of Si-H content of the at least one polysiloxane ranges from 2 to 50 percent; and
(ii) at least one molecule which comprises at least one primary hydroxyl group and at least one unsaturated bond capable of undergoing a hydrolysation reaction.

Preferably the metal nano powder of the ink and the above-mentioned anti abrasive promoting nano particles/flexible promoting polymers are crosslinked according to the invention. Preferably the cross linking is carried out during the sintering of the ink which is preferably carried after the ink jet printing of the ink, for example after the ink jet printing of the ink for forming conductive lines on a substrate.

According to the invention the method for producing a metal ink with improved abrasion resistance is characterised by mixing anti abrasive promoting nano particles and/or flexible promoting polymers into common metal ink. Preferably colloidal and/or fumed silica nano particles and/or sol-gel nano particles and/or carbon nano particles are used as anti abrasive promoting nano particles and silicone polymers and/or functionalised silicone polymers are used as flexible promoting polymers.

In a preferred embodiment of the invention the mixing process is performed by sonication. Preferably a surface modification of silica particles is performed by condensation reactions with silanes having at least one metal adhesion functional group, wherein the metal adhesion functional group has at least one N, O, S and/or P-atom. Preferably the metal adhesion functional group is selected from amine, diamine, triamine, tetraamine, polyamine, pyridine, imidazole, carboxylic acid, sulfonic acid, phosphate, phosphonate or phenol.

In another preferred embodiment it is proposed that the sol-gel nano particles are synthesised from co-condensation reactions of organo(alkoxy)-silanes with at least one organic functional group, wherein at least N, O, S and/or P-atom is present or transition metal alkoxides or their copolymerisation reactions with each other or with organic molecules are present.
According to the invention a substrate for a display having a plurality of ink jet printed conductive lines with improved adhesion of ink jet printed conductive lines and/or improved abrasion resistance and the flexibility of ink jet printed conductive lines comprises a metal adhesion promoting layer which is disposed between said ground substrate and conductive lines and the substrate furthermore comprises colloidal and/or fumed silica nano particles and/or sol-gel nano particles and/or carbon nano particles and/or silicone polymers and/or functionalised silicone polymers which are attached to said ground substrate and to said conductive lines.

Preferably the metal adhesion promoting layer comprises crosslinked molecules of the formula (VI),

YRₙ n = 2,3 (VI)

wherein Y is a N-, S- or a P-atom and R is a H-atom and/or at least one alkylgroup, or
crosslinked molecules of the formula (VII),

Z R'ₘ m = 2,3 (VII)

wherein Z is a N-, S- or a P-atom and R' is a H-atom and/or at least one silane group with the formula (VIII)

Si R"₃ (VIII)

wherein R*''* is an alkylgroup, which may be identical or different, or crosslinked molecules the formula (IX)

R Si X₄ (IX)

wherein R is a H-atom, an OH-group, a Cl-atom and/or an alkoxy group and X are each independently a H-atom, an OH-group, a Cl-atom, an alkoxy group, an alkyl group and/or organic group, wherein the organic group comprises at least one metal binding group.

Preferably the organic group comprises at least amine, diamine, triamine, tetraamine, polyamine, amide, polyamide, hydrazine, pyridine, imidazole, thiophene, carboxylic acid, carboxylic acid halogenide, sulfide, disulfide, trisulfide, tetrasulfide, polysulfide, sulfonic acid, sulfonic acid halogenide, phosphate, phosphonate, epoxide, phenol and/or polyether.

A method for the manufacture of a substrate for a display having a plurality of conductive lines with improved adhesion and/or improved abrasion resistance and the flexibility of ink jet printed conductive lines comprises the steps of:
- application of a metal adhesion promoting layer on a ground substrate,
- application of a plurality of conductive lines by ink jet printing of a metal ink,
wherein a metal ink comprising at least one of:
- colloidal and/or fumed silica nano particles
- sol-gel nano particles
- carbon nano particles
- silicone polymers
- functionalised silicone polymers
is used for the ink jet printing process.

Preferably the metal adhesion promoting layer is applied by a plasma treatment of NH₃, H₂S and/or PH₃ or a plasma treatment of a substance of the formula (VI) or a plasma polymerisation of a silane with the formula (VII). Preferably a substance of the formula (IX) is used for the application of the metal adhesion promoting layer. Preferably the metal adhesion promoting layer is applied by a wet chemistry process. In a preferred embodiment the metal adhesion promoting layer is applied by dipping the ground substrate into a solution of a substance of the formula (VI).

### BRIEF DESCRIPTION OF THE DRAWINGS

The present invention will now be described by way of example with reference to the accompanying drawings, in which:
- Fig. 1: shows a substrate according to the invention in a sectional view,
- Fig. 2a - 2c: show the synthesis of amino-functionalized silica particles and their crosslinking to silver nano particles,
- Fig. 2d - 2f: show the synthesis of epoxy-functionalized silica particles and their crosslinking to silver nano particles,
- Fig. 3a: shows the synthesis of epoxy-functionalized polysiloxane,
- Fig. 3b: shows the crosslinking of epoxy-functionalized polysiloxane to amino-functionalized silica particles and
- Fig. 3c: shows the crosslinking of epoxy-functionalized polysiloxane to the adhesion promoting layer.

### DETAILED DESCRIPTION OF PREFERRED EMBODIMENTS

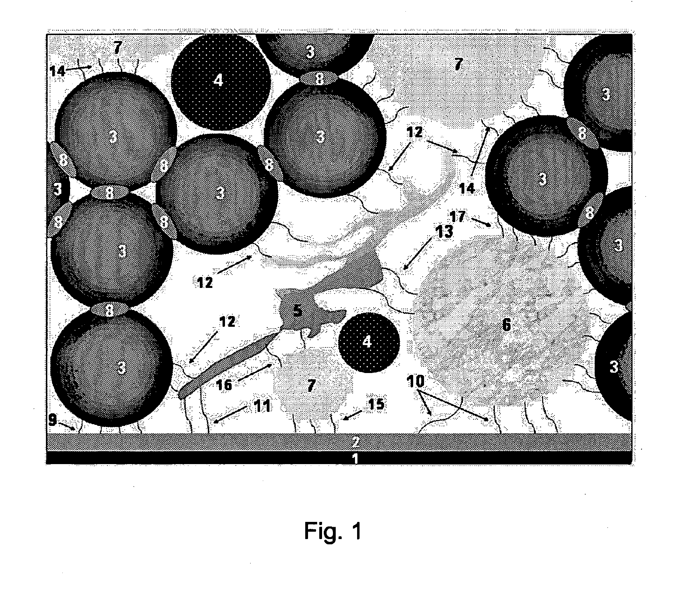

Fig. 1 shows a substrate according to the invention in a sectional view. Crosslinked anti abrasive promoting nano particles 4, 6, 7 and flexible promoting polymers 5 (epoxy-functionalised polysiloxane) are crosslinked to silver nano particles 3 (diameter preferably from 1-50 nm) and to ground substrate 1 via the adhesion promoting layer 2 (plasma polymerized hexamethylsilazane). Sol gel silica particles 6, silica particles 7 (for example AEROSIL R-900 from Degussa AG) and dispersed carbon particles 4 (for example PRINTEX L6 from CABOT Corp.) are bound to the silver particles 3 in order to improve the abrasion resistance of conductive lines formed by the metal nano ink. Furthermore the flexibility of the sintered metal nano ink is improved by flexible silicone polymers 5.

Conductive lines formed by sintered ink (from the substances as described above) on the ground substrate 1 (ITO coated glass substrate) and the metal adhesion promoting layer 2 (plasma polymerized hexamethylsilazane) results in better abrasion resistance and better flexibility of said conductive lines.

The silver particles 3 are bound to each other via the linkages 8. The flexible silicone polymer 5 is bound via the linkages 11 to the metal adhesion promoting layer 2. The flexible silicone polymer 5 is bound via the linkages 12 to the silver particles 3. The flexible silicone polymer 5 is bound via the linkages 13 to the sol gel particles 6. The silica particles 7 are bound via the linkages 14 to the silver particles 3. The silica particles 7 are bound via the linkages 15 to the metal adhesion promoting layer 2. The flexible silicone polymer 5 is bound via the linkages 16 to the silica particles 7. The silver particles 3 are bound via the linkages 17 to the sol gel particles 6.

A typical manufacturing process of a metal ink composition including abrasion resistance, adhesion and flexibility promoting nanoscaled additive composites can be described as follows:

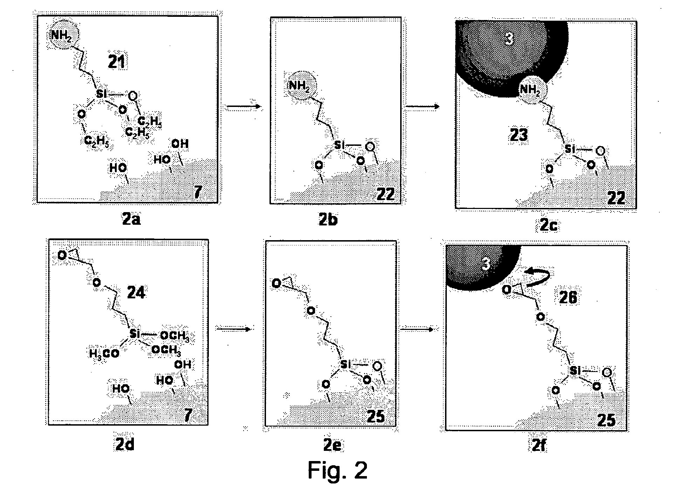

At a first step amino-functionalised silica particles 22 are prepared as shown in Fig. 2a - 2b. 10 g of silica particles 7 (for example AEROSIL R-900 from Degussa AG) are dispersed in 300 ml of a 10⁻¹-10⁻³ mol/l ethanol solution of (3-aminopropyl)triethoxysilane 21 (functioning as a metal adhesion promoting silane). The mixture is stirred for 1-20 hours at 40-50°C and is dried at 40-100°C. The yielded amino-functionalised silica particles 22 are stored at room temperature.

At a second step epoxy-functionalised silica particles 25 are prepared as shown in Fig. 2d - 2e. 10 g of silica particles 7 (for example AEROSIL R-900 from Degussa AG) are dispersed in 300 ml of a 10⁻¹-10⁻³ mol/l ethanol solution of (3-glycidoxypropyl)trimethoxysilane 24 (functioning as a metal adhesion promoting silane). The mixture is stirred for 1-20 hours at 40-50°C and is dried at 40-70 °C. The yielded epoxy-functionalised silica particles 25 are stored at room temperature.

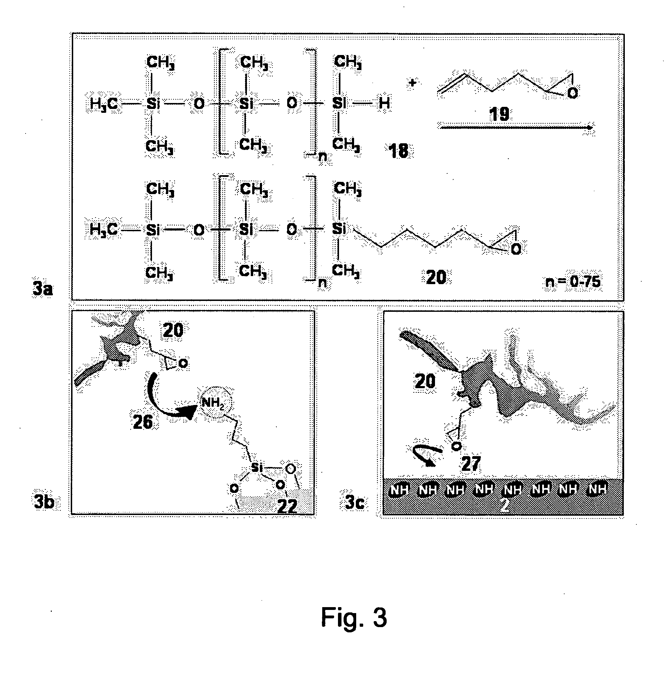

At a third step epoxy-functionalised polysiloxane 20 is prepared as shown in Fig. 3a. To a reaction vessel 10 g 1,2-epoxy-5-hexene 19 and an amount of sodium bicarbonate equivalent to 20 to 25 ppm of total monomer solids is added under nitrogen atmosphere and the temperature is gradually increased up to 75°C. At this temperature 5 % of a total amount of 7,1 g polysiloxane containing silicone hydride 18 (for example MASILWAX BASE from BASF Corp.) is added under agitation, followed by the addition of 0,02 g toluene, 0,005 g isopropanol and an equivalent to 10 ppm of chloroplatinic acid based on total monomer solids. The reaction is then allowed to exotherm to 95°C at which time the remainder of the polysiloxane (containing silicone hydride) is added at a rate such that the temperature does not exceed 95°C. After completion of this addition, the reaction temperature is maintained at 95°C and monitored by infrared spectroscopy for disappearance of the silicone hydride absorption band (Si-H, 2150 cm⁻¹).

In a fourth step the above prepared amino-functionalised silica particles 22 (see Fig. 2b), epoxy-functionalised silica particles 24 (see Fig. 2e) and the epoxy-functionalised polysiloxane 20 (see Fig. 3a) as well as milled carbon nano particles 4 (e. g. PRINTEX L6 from CABOT Corp.) and silver ink (i.e. silver nano particles 3 dissolved in a solvent) are mixed by a sonication process. The weight percentages of these additives range from 0.1-20. The epoxy-functionalised polysiloxane 20 can be bonded to amino-functionalised silica particles 22 as shown in Fig. 3b. The silver particles 3 can be bonded to amino-functionalised silica particles 22 as shown in Fig. 2c. Alternatively the silver particles 3 can be bonded to epoxy-functionalised silica particles 24 as shown in Fig. 2f.

The obtained silver nano ink composition can be ink jet printed on a ground substrate 1 having a adhesion promoter layer 2 (plasma polymerized hexamethylsilazane) using a multinozzle ink jet printer. The bonding of epoxy-functionalised polysiloxane 20 to the adhesion promoter layer 2 is shown in Fig. 3c. To receive solid ink jet printed conductive lines the printed ground substrate is heated at 100-250°C for 20-70 minutes. The obtained substrate can be used for further process steps of a PDP manufacturing process.

Ink jet printing of the silver nano ink composition results in an improvement of abrasion resistance, adhesion and flexibility of the cured silver line, which is important for high process requirements in PDP manufacturing, specially in the case of ink jet printed address and bus electrodes on flexible substrates.

In principle, the presence of cross-linked ink additives, based on Si-O-C, C-N-C, C-N, C-O, C-S and C-P linkages can be detected by ESCA (Electron Spectroscopy for Chemical Analysis) and ATR-FTIR (Attenuated Total Reflectance Fourier Transform Infrared Spectroscopy). The average particle size can be determined by visually examining an electron micrograph of a transmission electron microscopy (TEM), measuring the diameter of the particles in the image, and calculating the average particle size based on the magnification of the TEM image.

While this invention has been described in conjunction with specific embodiments thereof, it is evident that many alternatives, modifications and variations will be apparent to those skilled in the art. Accordingly, the preferred embodiments of the invention as set forth herein are intended to be illustrative, not limiting. Various changes may be made without departing from the spirit of the invention as defined in the following claims.

### List of Reference Signs

- 1: Ground Substrate
- 2: Adhesion Promoting Layer
- 3: Silver Particle
- 4: Carbon Particle
- 5: Flexible Silicone Polymer
- 6: Sol-gel Particle
- 7: Silica Particle
- 8: Linkage Between Sintered Silver Nano particles
- 9: Silver Nano particles/Adhesion Promoting Layer Crosslink
- 10: Sol-gel Particles/Adhesion Promoting Layer Crosslink
- 11: Flexible Silicone Polymer/Adhesion Promoting Layer Crosslink
- 12: Silver Nano particles/Flexible Silicone Polymer Crosslink
- 13: Sol-Gel Particles/Flexible Silicone Polymer Crosslink
- 14: Silica Particles/Silver Nano particles Crosslink
- 15: Silica Particle/Adhesion Promoting Layer Crosslink
- 16: Flexible Silicone Polymer/Silica Particle Crosslink
- 17: Sol-gel Particle/Silver Nano particles Crosslink
- 18: Polysiloxane Hydride
- 19: 1,5-Epoxy-5-Hexene
- 20: Epoxy-functionalized Flexible Silicone Polymer
- 21: (3-Aminopropyl)triethoxysilane
- 22: Amino-functionalized Silica Particle
- 23: Amino-functionalized Silica Particle/Silver Nano particles Crosslink
- 24: (3-Glycidoxypropyl)trimethoxysilane
- 25: Epoxy-functionalized Silica Particle
- 26: Epoxy-functionalized Silica Particle/ Silver Nano particles Crosslink
- 27: Epoxy-functionalized Flexible Silicone Polymer/ Adhesion Promoting Layer Crosslink

## Claims

1. Metal ink for ink jet printing of conductive lines comprising dispersed metal nano powder (3) and a solvent, **wherein** the metal ink comprises
- anti abrasive promoting nano particles and
- flexible promoting polymers (5, 20),
wherein the
anti abrasive promoting nano particles are
- colloidal and/or fumed silica nano particles (7, 22, 25) and/or
- sol-gel nano particles (6) and/or
- carbon nano particles (4) and
**wherein the**
flexible promoting polymers are
- silicone polymers (5) and/or
- functionalised silicone polymers (20).

2. Metal ink according to Claim 1, **wherein**
the silicone polymer (5, 20) comprises at least one polysiloxane of the formula (I):
R¹ₙR²ₘSiO_{(4-n-m)/2} (I)
wherein each R¹, which may be identical or different, represents H, OH, a monovalent hydrocarbon group or a monovalent siloxane group; each R² which may be identical or different, represents a group comprising at least one reactive functional group, wherein m and n fulfil the requirements of 0<n<4, 0<m<4 and 2≤(m+n)<4.

3. Metal ink according to Claim 2, **wherein**
wherein each R², which may be identical or different, represents a group comprising at least one reactive functional group selected from a hydroxyl group, a carboxyl group, an isocyanate group, a blocked polyisocyanate group, a primary amine group, a secondary amine group, an amide group, a carbamate group, a urea group, a urethane group, a vinyl group, an unsaturated ester group, a maleimide group, a fumarate group, an anhydride group, a hydroxy alkylamide group, and an epoxy group.

4. Metal ink according to Claim 1, **wherein**
the silicone polymer (5, 20) comprises at least one polysiloxane of the formula (II) or (III)
R₃Si-O-(SiR₂O-)ₙ-(SiRR^{a}O)ₘ,-SiR₃ (II)
R^{a}R₂Si-O-(SiR₂O-)ₙ-(SiRR^{a}O)ₘ-SiR₂Rₐ (III)
wherein
m has a value of at least 1;
m' ranges from 0 to 75;
n ranges from 0 to 75;
n' ranges from 0 to 75;
each R, which may be identical or different, is selected from H, OH, monovalent hydrocabon groups, monovalent siloxane groups, and mixtures of any of the foregoing; and
R^{a} comprises the following formula (IV):
-R³-X (IV)
wherein
-R³ is selected from an alkylene group, an oxyalkylene group, an alkylene aryl group, an alkenylene group, an oxyalkenylene group, and an alkenylene aryl group; and
X represents a group which comprises at least one reactive functional group selected from a hydroxyl group, a carboxyl group, an isocyanate group, a blocked polyisocyanate group, a primary amine group, a secondary amine group, an amide group, a carbamate group, a urea group, a urethane group, a vinyl group, an unsaturated ester group, a maleimide group, a fumarate group, an anhydride group, a hydroxy alkylamide group, and an epoxy group.

5. Metal ink according to Claim 1, **wherein**
the silicone polymer (5, 20) comprises at least one polysiloxane which is the reaction product of at least one the following reactants:
(i) at least one polysiloxane of the formula (V):
R₃Si-O-(SiR₂O-)ₙ-SiR₃ (V)
wherein each substituent group R, which may be identical or different, represents a group selected from H, OH, a monovalent hydrocarbon group, a siloxane group, and mixtures of any of the foregoing; at least one of the groups represented by R is H, and n' ranges from 0 to 100, so that the percent of Si-H content of the at least one polysiloxane ranges from 2 to 50 percent; and
(ii) at least one molecule which comprises at least one primary hydroxyl group and at least one unsaturated bond capable of undergoing a hydrolysation reaction.

6. Metal ink according to one of the preceding Claims, **wherein** the metal nano powder (3) and the additives are crosslinked.

7. Method for producing a metal ink with improved abrasion resistance,
**wherein**
- dispersed metal nano powder (3) and
- a solvent
- anti abrasive promoting nano particles and
- flexible promoting polymers
are mixed,
**wherein** the anti abrasive promoting nano particles are
- colloidal and/or fumed silica nano particles (7, 22, 25) and/or
- sol-gel nano particles (6) and/or
- carbon nano particles (4) and
**wherein** the flexible promoting polymers are
- silicone polymers (5) and/or
- functionalised silicone polymers (20).

8. Method according to one of the Claims 7, **wherein** the mixing process is performed by sonication.

9. Method according to Claim 8, **wherein**
a surface modification of silica particles (7) is performed by condensation reactions with silanes (21, 24) having at least one metal adhesion functional group, wherein the metal adhesion functional group has at least one N, O, S and/or P-atom.

10. Method according to Claim 9, **wherein**
the metal adhesion functional group is selected from amine, diamine, triamine, tetraamine, polyamine, pyridine, imidazole, carboxylic acid, sulfonic acid, phosphate, phosphonate and/or phenol.

11. Method according to Claim 7, **wherein**
the sol-gel nano (6) particles are synthesised from co-condensation reactions of organo(alkoxy)-silanes with at least one organic functional group, wherein at least N, O, S and/or P-atom is present or transition metal alkoxides or their copolymerisation reactions with each other or with organic molecules are present.

12. Substrate for a display comprising
a ground substrate (1) having a plurality of conductive lines comprising cross-linked metal nano powder, anti abrasive promoting nano particles and flexible promoting polymers, wherein the anti abrasive promoting nano particles are selected from :
- colloidal and/or fumed silica nano particles (7, 22, 25) and/or
- sol-gel nano particles (6) and/or
- carbon nano particles (4)
and the flexible promoting polymers are selected from:
- silicone polymers (5) and/or
- functionalised silicone polymers (20)
and a metal adhesion promoting layer (2) and said conductive lines are attached to said metal adhesion promoting layer (2),
and
the metal adhesion promoting layer (2) comprises crosslinked molecules of the formula (VI),
YRₙ n = 2,3 (VI)
wherein Y is a N-, S- or a P-atom and R is a H-atom and/or at least one alkyl group,
crosslinked molecules of the formula (VII),
Z R'ₘ m = 2,3 (VII)
wherein Z is a N-, S- or a P-atom and R' is a H-atom and/or at least one silane group with the formula (VIII)
SiR"₃ (VIII)
wherein R" is an alkyl group, which may be identical or different, or crosslinked molecules the formula (IX)
R Si X₄ (IX)
wherein R is a H-atom, an OH-group, a Cl-atom and/or an alkoxy group and X are each independently a H-atom, an OH-group, a Cl-atom, an alkoxy group, an alkyl group and/or organic group, wherein the organic group comprises at least one metal binding group.

13. Substrate according to Claim 12, **wherein**
the organic group comprises at least amine, diamine, triamine, tetraamine, polyamine, amide, polyamide, hydrazine, pyridine, imidazole, thiophene, carboxylic acid, carboxylic acid halogenide, sulfide, disulfide, trisulfide, tetrasulfide, polysulfide, sulfonic acid, sulfonic acid halogenide, phosphate, phosphonate, epoxide, phenol and/or polyether.

14. Method for the manufacture of a substrate for a display having a plurality of conductive lines comprising the steps of:
- application of a metal adhesion promoting layer (2) on a ground substrate (1),
- application of a plurality of conductive lines by ink jet printing of a metal ink,
**wherein**
a metal ink comprising cross-linked metal nano powder, anti abrasive promoting nano particles and flexible promoting polymers and wherein the anti abrasive promoting nano particles are selected from:
- colloidal and/or fumed silica nano particles (7, 22, 25) and/or
- sol-gel nano particles (6) and/or
- carbon nano particles (4)
and wherein the flexible promoting polymers are selected from
- silicone polymers (5) and/or
- functionalised silicone polymers (20)
is used for the ink jet printing process for forming the conductive lines,
and
the metal adhesion promoting layer (2) is applied by:
a plasma treatment of NH₃, H₂S and/or PH₃
or
a plasma treatment of a substance of the formula (VI)
or
a plasma polymerisation of a silane with the formula (VII).

15. Method according to Claim 14, **wherein**
a substance of the formula (IX) is used for the application of the metal adhesion promoting layer (2).

16. Method according to one the Claims 14 or 15, **wherein**
the metal adhesion promoting layer (2) is applied by a wet chemistry process.

17. Method according to Claim 16, **wherein**
the metal adhesion promoting layer (2) is applied by dipping the ground substrate (1) into a solution of a substance of the formula (VI).

18. Use of a metal ink according to any one of claims 1 to 6 for the forming of a plurality of conductive lines on a substrate for a display, wherein metal nano powder, anti abrasive promoting nano particles, being colloidal and/or fumed silica nano particles (7, 22, 25) and/or sol-gel nano particles (6) and/or carbon nano particles (4), and flexible promoting polymers being silicone polymers (5) and/or functionalised silicone polymers (20) are cross-linked during the sintering of the ink after the ink jet printing of the ink.

## Patentansprüche

1. Metalltinte zum Tintenstrahldrucken leitender Verbindungen, die dispergiertes Metallnanopulver (3) sowie ein Lösungsmittel umfasst, **wobei** die Metalltinte Folgendes umfasst:
- verschleißschutzfördernde Nanopartikel und
- flexibilitätsfördernde Polymere (5, 20),
**wobei die**
verschleiß schutzfördernden Nanopartikel
- kolloidale und/oder pyrogene Silica-Nanopartikel (7, 22, 25) und/oder
- Sol-Gel-Nanopartikel (6) und/oder
- Kohlenstoff-Nanopartikel (4) sind und
**wobei die**
flexibilitätsfördernden Polymere
- Silikonpolymere (5) und/oder
- funktionalisierte Silikonpolymere (20) sind.

2. Metalltinte gemäß Anspruch 1, **wobei**
das Silikonpolymer (5, 20) mindestens ein Polysiloxan der Formel (I) umfasst:
R¹ₙR²ₘSiO_{(4-n-m)/2} (I)
wobei jedes R¹, das identisch oder verschieden sein kann, H, OH, eine monovalente Kohlenwasserstoffgruppe oder eine monovalente Siloxangruppe repräsentiert; jedes R², das identisch oder verschieden sein kann, repräsentiert eine Gruppe, die mindestens eine reaktive funktionale Gruppe umfasst, wobei m und n den Bedingungen 0<n<4, 0<m<4 und 2≤(m+n)<4 genügen.

3. Metalltinte gemäß Anspruch 2, **wobei**
wobei jedes R², das identisch oder verschieden sein kann, eine Gruppe repräsentiert, die mindestens eine aus einer Hydroxylgruppe, einer Carboxylgruppe, einer Isocyanatgruppe, einer blockierten Polyisocyanatgruppe, einer primären Amingruppe, einer sekundären Amingruppe, einer Amidgruppe, einer Carbamatgruppe, einer Harnstoffgruppe, einer Urethangruppe, einer Vinylgruppe, einer ungesättigten Estergruppe, einer Maleimidgruppe, einer Fumaratgruppe, einer Anhydridgruppe, einer Hydroxyalkylamidgruppe und einer Epoxidgruppe ausgewählte reaktive funktionale Gruppe umfasst.

4. Metalltinte gemäß Anspruch 1, **wobei**
das Silikonpolymer (5, 20) mindestens ein Polysiloxan der Formel (II) oder (III) umfasst:
R₃S1-O-(SiR₂O-)ₙ-(SiRR^{a}O)ₘ SiR₃ (II)
R^{a}R₂Si-O-(SiR₂O-)ₙ-(SiRR^{a}O)ₘ-SiR₂R^{a} (III)
wobei
m einen Wert von mindestens 1 besitzt;
m' zwischen 0 und 75 liegt;
n zwischen 0 und 75 liegt;
n' zwischen 0 und 75 liegt;
jedes R, das identisch oder verschieden sein kann, aus H, OH, monovalenten Kohlenwasserstoffgruppen, monovalenten Siloxangruppen und Mischungen irgendwelcher der vorhergehenden ausgewählt ist; und
R^{a} die folgende Formel (IV) umfasst:
-R³-X (IV)
wobei
- R³ aus einer Alkylengruppe, einer Oxyalkylengruppe, einer Alkylenarylgruppe, einer Alkenylengruppe, einer Oxyalkenylengruppe und einer Alkenylenarylgruppe ausgewählt ist; und
X eine Gruppe repräsentiert, die mindestens eine aus einer Hydroxylgruppe, einer Carboxylgruppe, einer Isocyanatgruppe, einer blockierten Polyisocyanatgruppe, einer primären Amingruppe, einer sekundären Amingruppe, einer Amidgruppe, einer Carbamatgruppe, einer Harnstoffgruppe, einer Urethangruppe, einer Vinylgruppe, einer ungesättigten Estergruppe, einer Maleimidgruppe, einer Fumaratgruppe, einer Anhydridgruppe, einer Hydroxyalkylamidgruppe und einer Epoxidgruppe ausgewählte reaktive funktionale Gruppe umfasst.

5. Metalltinte gemäß Anspruch 1, **wobei**
das Silikonpolymer (5, 20) mindestens ein Polysiloxan umfasst, das das Reaktionsprodukt mindestens eines der folgenden Reaktanten ist:
(i) mindestens ein Polysiloxan der Formel (V):
R₃Si-O-(SiR₂O-)ₙ,-SiR₃ (V)
wobei jede Substituentengruppe R, die identisch oder verschieden sein kann, eine aus H, OH, einer monovalenten Kohlenwasserstoffgruppe, einer Siloxangruppe und Mischungen irgendwelcher der vorhergehenden ausgewählte Gruppe repräsentiert; mindestens eine der durch R repräsentierten Gruppen H ist und n' zwischen 0 und 100 liegt, so dass der Prozentsatz des Si-H-Gehalts des mindestens einen Polysiloxans zwischen 2 und 50 Prozent liegt; und
(ii) mindestens ein Molekül, das mindestens eine primäre Hydroxylgruppe und mindestens eine ungesättigte Bindung umfasst, die in der Lage ist, eine Hydrolysierungsreaktion einzugehen.

6. Metalltinte gemäß einem der vorhergehenden Ansprüche, **wobei**
das Metallnanopulver (3) und die Zusatzstoffe vernetzt sind.

7. Verfahren zur Produktion einer Metalltinte mit verbesserter Verschleiß festigkeit,
**wobei**
- dispergiertes Metallnanopulver (3) und
- ein Lösungsmittel
- verschleißschutzfördernde Nanopartikel sowie
- flexibilitätsfördernde Polymere
gemischt werden,
**wobei** die verschleißschutzfördernden Nanopartikel
- kolloidale und/oder pyrogene Silica-Nanopartikel (7, 22, 25) und/oder
- Sol-Gel-Nanopartikel (6) und/oder
- Kohlenstoff-Nanopartikel (4) sind und
wobei die flexibilitätsfördernden Polymere
- Silikonpolymere (5) und/oder
- funktionalisierte Silikonpolymere (20) sind.

8. Verfahren gemäß einem der Ansprüche 7,**wobei**
der Mischprozess durch Beschallung durchgeführt wird.

9. Verfahren gemäß Anspruch 8, **wobei**
eine Oberflächenveränderung von Silicapartikeln (7) durch Kondensationsreaktionen mit Silanen (21, 24) mit mindestens einer funktionalen Gruppe zur Metallhaftung durchgeführt wird, wobei die funktionale Gruppe zur Metallhaftung mindestens ein N-, O-, S- und/oder P-Atom aufweist.

10. Verfahren gemäß Anspruch 9, **wobei**
die funktionale Gruppe zur Metallhaftung aus Amin, Diamin, Triamin, Tetraamin, Polyamin, Pyridin, Imidazol, Carbonsäure, Sulfonsäure, Phosphat, Phosphonat und/oder Phenol ausgewählt wird.

11. Verfahren gemäß Anspruch 7, **wobei**
die Sol-Gel-Nanopartikel (6) aus Cokondensationsreaktionen von Organo(alkoxy)silanen mit mindestens einer organischen funktionalen Gruppe synthetisiert werden, wobei mindestens N-, O-, S- und/oder P-Atom vorhanden ist oder Übergangsmetallalkoxide oder deren Copolymerisationsreaktionen miteinander oder mit organischen Molekülen vorhanden sind.

12. Substrat für eine Anzeige, umfassend:
ein Grundsubstrat (1) mit einer Vielzahl von leitenden Verbindungen, die vernetztes Metallnanopulver, verschleißschutzfördernde Nanopartikel sowie flexibilitätsfördernde Polymere umfassen, wobei die verschleißschutzfördernden Nanopartikel aus
- kolloidalen und/oder pyrogenen Silica-Nanopartikeln (7, 22, 25) und/oder
- Sol-Gel-Nanopartikeln (6) und/oder
- Kohlenstoff-Nanopartikeln (4)
ausgewählt sind und die flexibilitätsfördernden Polymere aus
- Silikonpolymeren (5) und/oder
- funktionalisierten Silikonpolymeren (20) ausgewählt sind,
sowie eine metallhaftungsfördernde Schicht (2), und besagte leitende Verbindungen sind an besagter metallhaftungsfördernder Schicht (2) befestigt,
und
die metallhaftungsfördernde Schicht (2) umfasst vernetzte Moleküle der Formel (VI),
YRₙ n = 2,3 (VI)
wobei Y ein N-, S- oder ein P-Atom ist und R ein H-Atom und/oder mindestens eine Alkylgruppe ist,
vernetzte Moleküle der Formel (VII),
Z R'ₘ m = 2,3 (VII)
wobei Z ein N-, S- oder ein P-Atom ist und R' ein H-Atom und/oder mindestens eine Silangruppe mit der Formel (VIII) ist,
Si R"₃ (VIII)
wobei R" eine Alkylgruppe ist, die identisch oder verschieden sein kann,
oder vernetzte Moleküle nach Formel (IX),
R Si X₄ (IX)
wobei R ein H-Atom, eine OH-Gruppe, ein Cl-Atom und/oder eine Alkoxygruppe ist und X jeweils unabhängig ein H-Atom, eine OH-Gruppe, ein Cl-Atom, eine Alkoxygruppe, eine Alkylgruppe und/oder eine organische Gruppe sind, wobei die organische Gruppe mindestens eine metallbindende Gruppe umfasst.

13. Substrat gemäß Anspruch 12, **wobei**
die organische Gruppe mindestens Amin, Diamin, Triamin, Tetraamin, Polyamin, Amid, Polyamid, Hydrazin, Pyridin, Imidazol, Thiophen, Carbonsäure, Carbonsäurehalogenid, Sulfid, Disulfid, Trisulfid, Tetrasulfid, Polysulfid, Sulfonsäure, Sulfonsäurehalogenid, Phosphat, Phosphonat, Epoxid, Phenol und/oder Polyether umfasst.

14. Verfahren zur Herstellung eines Substrats für eine Anzeige mit einer Vielzahl von leitenden Verbindungen, das folgende Schritte umfasst:
- Aufbringen einer metallhaftungsfördernden Schicht (2) auf einem Grundsubstrat (1),
- Aufbringen einer Vielzahl von leitenden Verbindungen durch Tintenstrahldrucken einer Metalltinte,
**wobei**
eine Metalltinte, die vernetztes Metallnanopulver, verschleißschutzfördernde Nanopartikel sowie flexibilitätsfördernde Polymere umfasst, wobei die verschleißschutzfördernden Nanopartikel aus
- kolloidalen und/oder pyrogenen Silica-Nanopartikeln (7, 22, 25) und/oder
- Sol-Gel-Nanopartikeln (6) und/oder
- Kohlenstoff-Nanopartikeln (4)
ausgewählt sind und wobei die flexibilitätsfördernden Polymere aus
- Silikonpolymeren (5) und/oder
- funktionalisierten Silikonpolymeren (20)
ausgewählt sind, für den Tintenstrahldruckprozess zur Ausbildung der leitenden Verbindungen verwendet wird
und
die metallhaftungsfördernde Schicht (2) durch
eine Plasmabehandlung von NH₃, H₂S und/oder PH₃
oder
eine Plasmabehandlung einer Substanz der Formel (VI)
oder
eine Plasmapolymerisation eines Silans mit der Formel (VII) aufgebracht wird.

15. Verfahren gemäß Anspruch 14, **wobei**
eine Substanz der Formel (IX) für die Aufbringung der metallhaftungsfördernden Schicht (2) verwendet wird.

16. Verfahren gemäß einem der Ansprüche 14 oder 15, **wobei**
die metallhaftungsfördernde Schicht (2) durch ein Nasschemieverfahren aufgebracht wird.

17. Verfahren gemäß Anspruch 16, **wobei**
die metallhaftungsfördernde Schicht (2) durch Eintauchen des Grundsubstrats (1) in eine Lösung einer Substanz der Formel (VI) aufgebracht wird.

18. Verwendung einer Metalltinte gemäß irgendeinem der Ansprüche 1 bis 6 zur Ausbildung einer Vielzahl von leitenden Verbindungen auf einem Substrat für eine Anzeige, wobei Metallnanopulver, verschleißschutzfördernde Nanopartikel, die kolloidale und/oder pyrogene Silica-Nanopartikel (7, 22, 25) und/oder Sol-Gel-Nanopartikel (6) und/oder Kohlenstoff Nanopartikel (4) sind, sowie flexibilitätsfördernde Polymere, die Silikonpolymere (5) und/oder funktionalisierte Silikonpolymere (20) sind, während des Sinterns der Tinte nach dem Tintenstrahldrucken der Tinte vernetzt werden.

## Revendications

1. Encre métallique pour l'impression à jet d'encre de lignes conductrices comprenant une nanopoudre métallique dispersée (3) et un solvant, dans laquelle l'encre métallique comprend
- des nanoparticules améliorant la résistance à l'abrasion et
- des polymères améliorant la flexibilité (5, 20),
dans laquelle
les nanoparticules améliorant la résistance à l'abrasion sont
- des nanoparticules de silice colloïdale et/ou pyrogénée (7, 22, 25) et/ou
- des nanoparticules de sol-gel (6) et/ou
- des nanoparticules de carbone (4) et
dans laquelle
les polymères améliorant la flexibilité sont
- des polymères de silicone (5) et/ou
- des polymères de silicone fonctionnalisés (20).

2. Encre métallique selon la revendication 1, dans laquelle
le polymère de silicone (5, 20) comprend au moins un polysiloxane de formule (I) :
R¹ₙR²ₘSiO_{(4-n-m) /2} (I)
où chacun des R¹, qui peuvent être identiques ou différents, représente H, OH, un groupe hydrocarboné monovalent ou un groupe siloxane monovalent ; chacun des R², qui peuvent être identiques ou différents, représente un groupe comprenant au moins un groupe fonctionnel réactif, et où m et n satisfont les conditions 0<n<4, 0<m<4 et 2≤(m+n)<4.

3. Encre métallique selon la revendication 2, dans laquelle
chacun des R², qui peuvent être identiques ou différents, représente un groupe comprenant au moins un groupe fonctionnel réactif choisi parmi un groupe hydroxyle, un groupe carboxyle, un groupe isocyanate, un groupe polyisocyanate bloqué, un groupe amine primaire, un groupe amine secondaire, un groupe amide, un groupe carbamate, un groupe urée, un groupe uréthanne, un groupe vinyle, un groupe ester insaturé, un groupe maléimide, un groupe fumarate, un groupe anhydride, un groupe hydroxyalkylamide et un groupe époxy.

4. Encre métallique selon la revendication 1, dans laquelle
le polymère de silicone (5, 20) comprend au moins un polysiloxane de formule (II) ou (III)
R₃Si-O- (SiR₂O-)ₙ- (SiRR^{a}O)ₘ-SiR₃ (II)
R^{a}R₂Si-O- (SiR₂O-) _{n'}- (SiRR^{a}O)_{m'}-SiR₂R^{a} (III)
où
m a une valeur d'au moins 1 ;
m' est compris entre 0 et 75 ;
n est compris entre 0 et 75 ;
n' est compris entre 0 et 75 ;
chacun des R, qui peuvent être identiques ou différents, est choisi parmi H, OH, des groupes hydrocarbonés monovalents, des groupes siloxane monovalents, et des mélanges de n'importe lesquels des précédents ; et
R^{a} comprend la formule (IV) suivant
-R³-X (IV)
où
- R³ est choisi parmi un groupe alkylène, un groupe oxyalkylène, un groupe alkylène-aryle, un groupe alcénylène, un groupe oxyalcénylène et un groupe alcénylène-aryle ; et
X représente un groupe qui comprend au moins un groupe fonctionnel réactif choisi parmi un groupe hydroxyle, un groupe carboxyle, un groupe isocyanate, un groupe polyisocyanate bloqué, un groupe amine primaire, un groupe amine secondaire, un groupe amide, un groupe carbamate, un groupe urée, un groupe uréthanne, un groupe vinyle, un groupe ester insaturé, un groupe maléimide, un groupe fumarate, un groupe anhydride, un groupe hydroxyalkylamide et un groupe époxy.

5. Encre métallique selon la revendication 1, dans laquelle
le polymère de silicone (5, 20) comprend au moins un polysiloxane qui est le produit de réaction d'au moins l'un des corps réactionnels suivants :
(i) au moins un polysiloxane de formule (V) :
R₃Si-O- (siR₂O-)_{n'}-SiR₃ (V)
où chacun des groupes substituants R, qui peuvent être identiques ou différents, représente un groupe choisi parmi H, OH, un groupe hydrocarboné monovalent, un groupe siloxane et des mélanges de n'importe lesquels des précédents ; au moins un des groupes représentés par R est H et n' est compris entre 0 et 100, en sorte que le pourcentage de teneur en Si-H dudit au moins un polysiloxane soit compris entre 2 et 50 pour cent ; et
(ii) au moins une molécule qui comprend au moins un groupe hydroxyle primaire et au moins une liaison insaturée capable de subir une réaction d'hydrolyse.

6. Encre métallique selon l'une des revendications précédentes, dans laquelle
la nanopoudre métallique (3) et les additifs sont réticulés.

7. Procédé de production d'une encre métallique ayant une résistance à l'abrasion améliorée, dans lequel
- une nanopoudre métallique dispersée (3) et
- un solvant
- des nanoparticules améliorant la résistance à l'abrasion et
- des polymères améliorant la flexibilité
sont mélangés,
dans lequel les nanoparticules améliorant la résistance à l'abrasion sont
- des nanoparticules de silice colloïdale et/ou pyrogénée (7, 22, 25) et/ou
- des nanoparticules de sol-gel (6) et/ou
- des nanoparticules de carbone (4) et
dans lequel les polymères améliorant la flexibilité sont
- des polymères de silicone (5) et/ou
- des polymères de silicone fonctionnalisés (20).

8. Procédé selon la revendication 7, dans lequel l'opération de mélange est effectuée par sonication.

9. Procédé selon la revendication 8, dans lequel une modification de surface des particules de silice (7) est effectuée par des réactions de condensation avec des silanes (21, 24) ayant au moins un groupe fonctionnel d'adhérence au métal, où le groupe fonctionnel d'adhérence au métal comporte au moins un atome de N, 0, S et/ou P.

10. Procédé selon la revendication 9, dans lequel le groupe fonctionnel d'adhérence au métal est choisi parmi les suivants : amine, diamine, triamine, tétraamine, polyamine, pyridine, imidazole, acide carboxylique, acide sulfonique, phosphate, phosphonate et/ou phénol.

11. Procédé selon la revendication 7, dans lequel les nanoparticules de sol-gel (6) sont synthétisées par des réactions de co-condensation d'organo(alkoxy)silanes avec au moins un groupe fonctionnel organique, où au moins un atome de N, O, S et/ou P est présent ou des alcoolates de métaux de transition ou leurs produits réactionnels de copolymérisation entre eux ou avec des molécules organiques sont présents.

12. Substrat pour dispositif d'affichage, comprenant un substrat de base (1) ayant une pluralité de lignes conductrices comprenant une nanopoudre métallique, des nanoparticules améliorant la résistance à l'abrasion et des polymères améliorant la flexibilité sous forme réticulée, les nanoparticules améliorant la résistance à l'abrasion étant choisies parmi :
- des nanoparticules de silice colloïdale et/ou pyrogénée (7, 22, 25) et/ou
- des nanoparticules de sol-gel (6) et/ou
- des nanoparticules de carbone (4)
et les polymères améliorant la flexibilité étant choisis parmi :
- des polymères de silicone (5) et/ou
- des polymères de silicone fonctionnalisés (20)
et une couche améliorant l'adhérence au métal (2) et lesdites lignes conductrices sont attachées à ladite couche améliorant l'adhérence au métal (2),
et
la couche améliorant l'adhérence au métal (2) comprend des molécules réticulées de formule (VI),
YRₙ n = 2, 3 (VI)
où Y est un atome de N, S ou P et R est un atome de H et/ou au moins un groupe alkyle,
des molécules réticulées de formule (VII),
ZR'ₘ ID m = 2, 3 (VII)
où Z est un atome de N, S ou P, et R' est un atome de H et/ou au moins un groupe silane ayant la formule (VIII)
SiR"₃ (VIII)
où les R" sont des groupes alkyle qui peuvent être identiques ou différents, ou des molécules réticulées de formule (IX)
R Si X₄ (IX)
où R est un atome de H, un groupe OH, un atome de Cl et/ou un groupe alkoxy, et les X sont chacun indépendamment un atome de H, un groupe OH, un atome de Cl, un groupe alkoxy, un groupe alkyle et/ou un groupe organique, le groupe organique comprenant au moins un groupe de liaison au métal.

13. Substrat selon la revendication 12, dans lequel
le groupe organique comprend au moins un des suivants : amine, diamine, triamine, tétraamine, polyamine, amide, polyamide, hydrazine, pyridine, imidazole, thiophène, acide carboxylique, halogénure d'acide carboxylique, sulfure, disulfure, trisulfure, tétrasulfure, polysulfure, acide sulfonique, halogénure d'acide sulfonique, phosphate, phosphonate, époxyde, phénol et/ou polyéther.

14. Procédé pour la fabrication d'un substrat pour dispositif d'affichage ayant une pluralité de lignes conductrices comprenant les étapes :
- d'application d'une couche améliorant l'adhérence au métal (2) sur un substrat de base (1),
- d'application d'une pluralité de lignes conductrices par impression à jet d'encre avec une encre métallique,
dans lequel
une encre métallique comprenant une nanopoudre métallique, des nanoparticules améliorant la résistance à l'abrasion et des polymères améliorant la flexibilité sous forme réticulée, les nanoparticules améliorant la résistance à l'abrasion étant choisies parmi :
- des nanoparticules de silice colloïdale et/ou pyrogénée (7, 22, 25) et/ou
- des nanoparticules de sol-gel (6) et/ou
- des nanoparticules de carbone (4)
et les polymères améliorant la flexibilité étant choisis parmi
- des polymères de silicone (5) et/ou
- des polymères de silicone fonctionnalisés (20)
est utilisée pour le procédé d'impression à jet d'encre pour former les lignes conductrices,
et
la couche améliorant l'adhérence au métal (2) est appliquée par :
traitement au plasma avec NH₃, H₂S et/ou PH₃
ou
traitement au plasma avec une substance de formule (VI)
ou
polymérisation au plasma d'un silane de formule (VII).

15. Procédé selon la revendication 14, dans lequel une substance de formule (IX) est utilisée pour l'application de la couche améliorant l'adhérence au métal (2).

16. Procédé selon l'une des revendications 14 ou 15, dans
lequel
la couche améliorant l'adhérence au métal (2) est appliquée par un traitement chimique par voie humide.

17. Procédé selon la revendication 16, dans lequel la couche améliorant l'adhérence au métal (2) est appliquée en plongeant le substrat de base (1) dans une solution d'une substance de formule (VI).

18. Utilisation d'une encre métallique selon l'une quelconque des revendications 1 à 6 pour la formation d'une pluralité de lignes conductrices sur un substrat pour dispositif d'affichage, dans laquelle une nanopoudre métallique, des nanoparticules améliorant la résistance à l'abrasion, qui sont des nanoparticules de silice colloïdale et/ou pyrogénée (7, 22, 25) et/ou des nanoparticules de sol-gel (6) et/ou des nanoparticules de carbone (4), et des polymères améliorant la flexibilité, qui sont des polymères de silicone (5) et/ou des polymères de silicone fonctionnalisés (20), sont réticulés pendant le frittage de l'encre après l'application de l'encre par impression à jet d'encre.
